# EUROPÄISCHE PATENTSCHRIFT

(11) **EP 2 504 920 B1**
(45) Veröffentlichungstag und Bekanntmachung des Hinweises auf die Patenterteilung: **14.09.2016**
(21) Anmeldenummer: 10785316.0
(22) Anmeldetag: 18.11.2010
(51) Int. Cl.: G01L 9/08, H03F 3/70, G01L 1/16, H03F 1/30

(54) **DIGITALER LADUNGSVERSTÄRKER UND VERFAHREN ZUM WANDELN VON LADUNGSSIGNALEN IN DIGITALE SIGNALE**
DIGITAL CHARGE AMPLIFIER AND METHOD FOR CONVERTING CHARGE SIGNALS INTO DIGITAL SIGNALS
AMPLIFICATEUR DE CHARGE NUMÉRIQUE ET PROCÉDÉ POUR CONVERTIR DES SIGNAUX DE CHARGE EN SIGNAUX NUMÉRIQUES

(30) Priorität: 25.11.2009 CH 18142009
(43) Veröffentlichungstag der Anmeldung: 03.10.2012
(73) Patentinhaber: Kistler Holding AG, 8408 Winterthur (CH)
(72) Erfinder: AMSTUTZ, Leo, CH-8413 Neftenbach (CH); NEFF, Kurt, CH-8472 Seuzach (CH); OTTER, Daniel, CH-8311 Brütten (CH)
(86) Internationale Anmeldenummer: PCT/CH2010/000289
(87) Internationale Veröffentlichungsnummer: WO 2011/063536

(56) Entgegenhaltungen:
- US-A- 3 921 012
- US-A- 3 989 961
- US-A- 4 109 168
- US-A- 5 523 642
- US-B1- 6 169 428

## Beschreibung

### Technisches Gebiet

Die Erfindung betrifft eine Ladungsverstärkerschaltung zum Wandeln von positiven und negativen von einem piezoelektrischen Messelement abgegebenen Ladungssignalen Q in ein digitales Signal D, welches dem jeweils aktuell vorherrschenden Messwert am Messelement proportional ist, umfassend einen Ladungsverstärker V1 mit einem Ladungseingang und einem Spannungsausgang zum Wandeln der erfassten Ladung Q in eine Spannung U2. Die Erfindung betrifft weiterhin ein Verfahren zum Wandeln von Ladungssignalen in digitale Signale D.

### Stand der Technik

Ladungsverstärker werden insbesondere im Zusammenhang mit piezoelektrischen Sensoren benötigt, da diese ihre Messwerte in Form von Ladungen angeben. Solche Sensoren erfassen beispielsweise Kräfte, Drucke, Beschleunigungen, Dehnungen, Momente und artverwandte physikalische Phänomene. Sobald solche Sensoren an beweglichen Teilen montiert sind, beispielsweise an Rädern von Fahrzeugen, müssen die Messsignale digitalisiert werden, um mittels berührungsloser Übertragung an einen Stator übertragen werden zu können. Hierzu werden die ermittelten Messwerte in der Regel in einem Ladungsverstärker verstärkt und mittels Analog-digital Wandler (A/D Wandler) umgewandelt, bis sie schliesslich übertragen werden.

Infolge unvermeidlicher Störströme am Verstärkereingang, welche dieselbe Wirkung wie die von Änderungen der Ladung Q herrührenden Ströme haben, wandert die Verstärkerausgangsspannung davon; sie driftet. Um diesen Störeffekt zu reduzieren, wird häufig ein Widerstand parallel zum Ladungsverstärker geschaltet, welcher die Zunahme der Ausgangsspannung infolge Drifts auf ein akzeptables Mass beschränkt. Der Widerstand wirkt aber in gleicher Weise auch auf das Messsignal. Die untere Grenzfrequenz des Ladungsverstärkers steigt damit auf oft nicht mehr tolerierbare Werte an. Wenn die Messung nur einen kurzen einmaligen Vorgang erfasst, kann man diesem Störeffekt durch Betätigen eines Reset-Schalters kurz vor dem Messvorgang entgegen wirken. Bei länger dauernden Messungen führt die Wahl des Wertes für den Widerstand häufig zu einem unbefriedigenden Kompromiss zwischen resultierender unterer Grenzfrequenz und der verbleibenden Drift des Ladungsverstärkers. Zudem ist bei einer berührungslosen Übertragung des Messwertes, beispielsweise bei einem bewegten Messobjekt, ein zusätzlicher Aufwand nötig, um den Reset-Schalter von der feststehenden Elektronik aus zu betätigen.

### Darstellung der Erfindung

Aufgabe der vorliegenden Erfindung ist es, eine Schaltung für einen Ladungsverstärker zum Wandeln von piezoelektrischen Messsignalen anzugeben, welche die erwähnten Probleme reduziert und zudem ohne Verwendung eines Analog/Digital-Wandlers ein Signal liefert, welches auf einfache Art berührungslos übertragen werden kann.

Die Erfindung besteht darin, dass das Ausgangssignal des Verstärkers laufend auf einen Wert in der Nähe von Null gesetzt wird, so dass sich ein Reset-Schalter erübrigt. Zudem stehen als Ausgangssignal Impulse zur Verfügung, welche leicht störungsarm zu übertragen sind. Die Impulsfrequenz ist proportional zur Ladungsänderungsgeschwindigkeit. Die in einem Zähler aufsummierten Impulse stellen einen der Ladungsänderung seit der letzten Zählerrückstellung proportionalen Wert dar, welcher proportional ist zu dem jeweils aktuell vorherrschenden Messwert am Messelement.

### Kurze Beschreibung der Zeichnungen

Im Folgenden wird die Erfindung unter Beizug der Zeichnungen näher erklärt. Es zeigen
- Fig. 1: eine schematische Darstellung einer erfindungsgemässen Schaltung;
- Fig. 2: eine Schaltung zur Verarbeitung eines Ladungssignals nach dem Stand der Technik;
- Fig. 3: eine schematische Darstellung einer erfindungsgemässen Schaltung in einem Realisierungsbeispiel mit gepulstem Kompensationsstrom;
- Fig. 4: eine bevorzugte Ausführungsform unter Einsatz von Dioden;
- Fig. 5: eine bevorzugte Ausführungsform einer erfindungsgemässen Schaltung unter Einsatz von Transistoren;
- Fig. 6: eine bevorzugte Ausführungsform einer erfindungsgemässen Schaltung mit konstantem Kompensationsstrom.

### Wege zur Ausführung der Erfindung

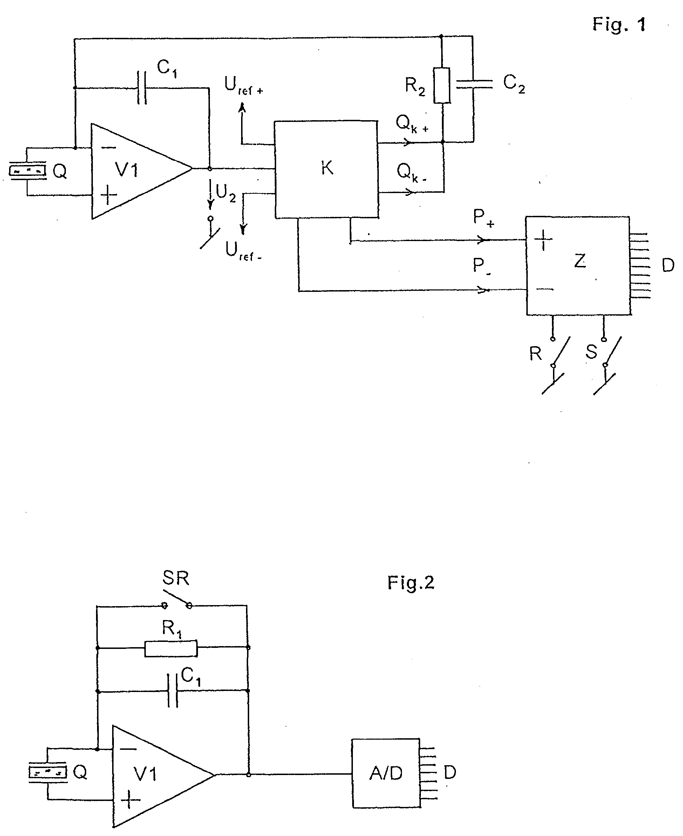

Fig. 1 zeigt in vereinfachter Darstellung die Funktionsweise einer erfindungsgemässen Ladungsverstärkerschaltung. Die von einem piezoelektrischen Messelement generierte, zu erfassende Ladung Q wird an den Eingang eines mit einem Kondensator C1 gegengekoppelten Verstärkers V1 gelegt. Sobald die Verstärkerausgangsspannung U2 den Referenzwert Uref+ bzw. Uref- über- bzw. unterschreitet, liefert die Kompensationsschaltung K so lange definierte Kompensationsladungen Qk+ bzw. Qk- über das Netzwerk R2/C2 an den Verstärkereingang, bis dessen Ausgangsspannung U2 wieder innerhalb der Schranken Uref+ bzw. Urefliegt. Mit jeder positiven Ladungseinheit Qk+ wird ein Impuls P-, mit jeder negativen Ladungseinheit Qk- ein Impuls P+ abgegeben.

Diese Impulse sind inkrementale Signale für die Ladungsänderungen am Eingang von V1, bzw. für den Eingangsstrom.

Summierung dieser Impulse in einem Auf-/Ab-Zähler Z ergibt ein Mass für die insgesamt vorgängig eingegangenen Ladung und liefert schliesslich das gewünschte digitale Signal D, das dem jeweils aktuell vorherrschenden Messwert am Messelement proportional ist. Vorzugsweise ist dieses Signal D ein Spannungssignal.

Diese Schaltung ist besonders vorteilhaft bei digitaler Messwertverarbeitung und bei Messungen an bewegten Objekten wegen der einfachen Übertragungsmöglichkeit der Impulse.

Eine übliche Schaltung zur Verarbeitung eines Ladungssignals nach dem Stand der Technik, wie sie beispielsweise in der piezoelektrischen Messtechnik Verwendung findet, ist in Fig. 2 gezeigt. Ein piezoelektrisches Messelement wird als Ladungsquelle Q an den Eingang eines integrierenden Verstärkers V1, in dieser Anwendung meist als Ladungsverstärker bezeichnet, angeschlossen. Parallel zu diesem Ladungsverstärker V1 sind ein Kondensator C1 sowie ein Reset-Schalter SR angelegt. Durch Schliessen des Reset-Schalters SR wird der Kondensator C1 entladen. Nach Öffnen dieses Schalters gelangt eine nach diesem Zeitpunkt angelegte Ladung Q auf den Kondensator C1 und bewirkt am Verstärkerausgang eine Spannung, welche Q/C1 beträgt. Wird ein digitales Signal D benötigt, so wird die Verstärkerausgangsspannung einem Analog/Digital-Wandler A/D zugeführt, an dessen Ausgang dann ein paralleles oder serielles Signal D zur Verfügung steht.

Ein Widerstand R1, der parallel zum Kondensator C1 geschaltet ist, soll die Zunahme der Ausgangsspannung infolge Drifts auf ein akzeptables Mass beschränken.

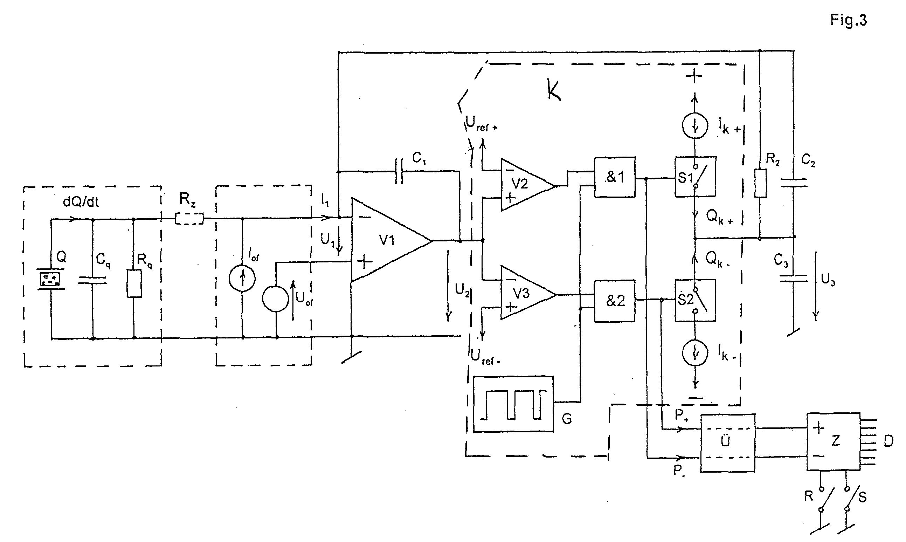

In Fig. 3 ist vereinfacht ein Realisierungsbeispiel einer erfindungsgemässen Schaltung dargestellt. Die Bauteile vor dem Verstärker V1 stellen die bei jeder piezoelektrischen Messvorrichtung vorhandenen Teile dar. Q ist die Ladungsquelle, vom piezoelektrischen Messelement erzeugt, dQ/dt stellt den infolge Änderungen von Q fliessenden Strom dar. Cq soll die gesamte Kapazität, Rq den gesamten Leckwiderstand der Eingangsschaltung, umfassend Ladungsquelle, Kabel und Verstärkereingang, beinhalten. Iof ist der Offsetstrom, Uof der Spannungsoffset des Verstärkers. I1 ist der gesamte von der Quelle in den Eingang des Verstärkers fliessende Strom, umfassend die von dQ/dt, Iof und Uof/Rq herrührenden Anteile. Bei einer Ausgangslage von U2 = 0 bewirkt ein Eingangsstrom I1 vorerst eine sehr kleine Eingangsspannung U1 am Eingang des Verstärkers V1 und eine Ausgangsspannung U2, welche den Wert Integral des Stromes I1 über die Zeit dividiert durch die Kapazität C1 aufweist. Wenn U2 den Wert Uref+ überschreitet (bei negativer Ladungszunahme am Eingang), spricht der Komparatorverstärker V2 an und liefert ein positives Ausgangssignal. Vom Impulsgenerator G gelangen in der Breite exakt definierte Impulse an die beiden AND-Glieder &1 und &2. Solange die Ausgangsspannung von V2 positiv ist, gelangen diese Impulse an den Ausgang des AND-Gliedes &1. Sie betätigen den Schalter S1, welcher die Stromquelle Ik+ jeweils während der Impulsdauer öffnet. Dadurch gelangt mit jedem Impuls eine wohldefinierte Kompensationsladung Qk+, welche gleich dem Wert der Kompensationsstromquelle Ik+ multipliziert mit der Impulsdauer ist, auf das Netzwerk R2, C2, C3. Diese Ladung Qk gelangt an den Verstärkereingang und kompensiert mindestens einen Teil der von der Quelle an V1 abgegebenen Ladung. Wenn nach einer genügenden Anzahl von Kompensationsladungen die Eingangsladung Q annähernd vollständig kompensiert ist, sinkt U2 wieder unter den Wert Uref+, wodurch die folgenden Impulse von G das AND-Glied &1 nicht mehr passieren können. Die vom AND-Glied abgegebenen Impulse gelangen auch als Impulse P an den Ausgang. Die Anzahl dieser Impulse ist gleich der auf den Eingang geflossenen Ladung dividiert durch die Kompensationsladung Qk und somit ein Mass für das Eingangssignal. Bei umgekehrtem Vorzeichen von Q (positive Ladungszunahme) treten in analoger Weise V3, das AND-Glied &2, S2 und Ik- in Funktion und bewirken Ausgangsimpulse P+.

Diese Impulse sind inkrementale Signale, welche proportional zu den Ladungsänderungen am Verstärkereingang sind. Die Häufigkeit bzw. Frequenz der Impulse P+ ist ein Mass für die positive Ladungszunahme, ebenso ist die Frequenz der Impulse Pein Mass für die Ladungsabnahme.

Meistens interessiert aber vor allem das Integral der Ladungsänderung ab einem bestimmten Zeitpunkt. In diesem Fall werden die Impulse in einem Auf-Ab-Zähler aufsummiert. Die Impulse P+ und P- gelangen über eine 2-kanalige Übertragungsstrecke Ü auf die beiden Eingänge eines Zählers Z. Dieser Zähler wird vorgängig mittels des Reset-Schalters R auf Null gesetzt. Zu Beginn des Messvorganges wird der Zähler mittels des Schalters S gestartet. Soll der Messwert in einem bestimmten Zeitpunkt festgehalten werden, kann der Zähler in diesem Zeitpunkt gestoppt werden und das Signal bleibt unabhängig von Drifteffekten im Verstärker V1 im Zähler erhalten. Der im Zähler Z enthaltene, der Ladung Q proportionale Wert kann auf bekannte Art als digitales Signal D parallel oder seriell ausgelesen und weiterverarbeitet werden.

Die Störeinflüsse am Verstärkereingang sind physikalisch bedingt und nicht völlig eliminierbar, da Iof und Uof zwar klein, aber nicht zu null gemacht werden können und da der Isolationswiderstand Rq immer einen endlichen Wert hat. Somit können auch mit dieser verbesserten Schaltung zwar nie echt statische Messungen der Ladung Q ausgeführt werden und der Widerstand R2 muss einen endlichen Wert aufweisen, um die Störströme abführen zu können. Jedoch ist ein leicht störungsfrei zu übertragendes inkrementales Signal vorhanden und eine Reset-Schaltung am Ladungsverstärker ist selbst nicht nötig. Vielmehr kann der Zähler jederzeit auf einfache und rasche Art auf null gesetzt werden.

Bei sprungartigen Signalen (grosser Ladungsanstieg in kurzer Zeit) wird der Zähler in vorteilhafter Weise vorgängig auf null gesetzt und kurz vor dem zu erwartenden Signalsprung gestartet.

Bei periodischen Signalen kann der Zähler auch ereignisgesteuert periodisch auf null gesetzt werden, beispielsweise zu Beginn jedes periodischen Vorganges.

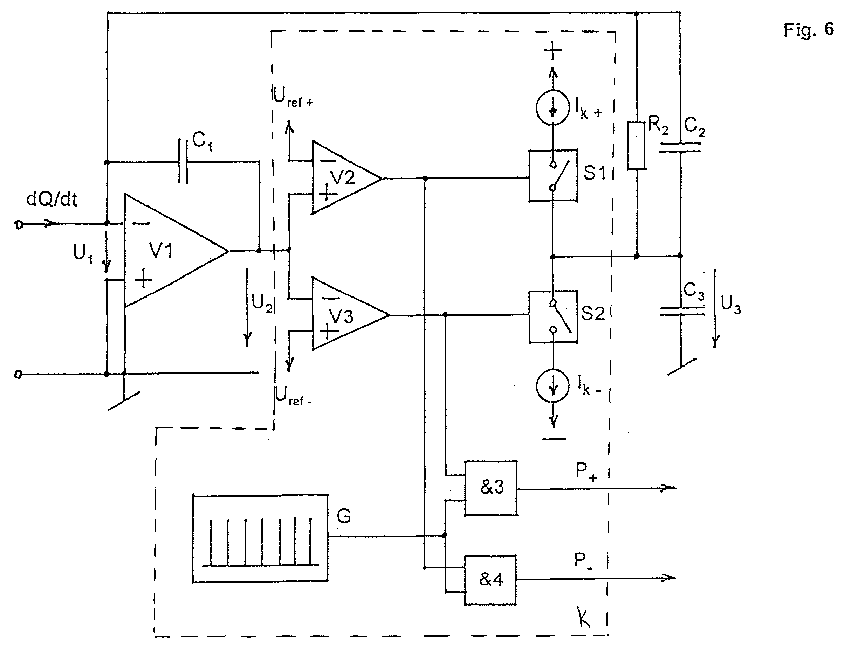

Fig. 6 zeigt eine etwas anders aufgebaute Schaltung, welche im wesentlichen dieselbe Funktion wie die in Fig. 3 beschriebene Schaltung hat.

Sie unterscheidet sich von dieser dadurch, dass bei positiver Ausgangsspannung des Verstärkers V2 der Schalter S1 öffnet und so lange den Kompensationsstrom Ik+ über das Netzwerk R2/C2 an den Verstärkereingang liefert, bis U2 wieder unter den Wert Uref sinkt. Die Ausgangsspannung von V2 liegt gleichzeitig am AND-Glied &4, welches während der Zeit, in welcher der Kompensationsstrom Ik fliesst, die Impulse des Impulsgenerators G als Ausgangsimpulse P- an den Ausgang abgibt. Die Anzahl dieser Impulse ist somit ebenfalls proportional zur Kompensationsladung und führt schliesslich zur Lieferung des digitalen Signals D.

Für positive Ladungsänderungen am Eingang gilt sinngemäss dasselbe für V3, S2 und &3. Die Schalter S1 und S2 schalten nur die Kompensationsströme.

Aus diesen Ausführungen sind insbesondere folgende Vorteile der Erfindung gegenüber herkömmlichen Schaltungsarten ersichtlich:
- Das Messsignal ist direkt inkremental, bei Verwendung eines Zählers digital, ohne Zwischenschaltung eines Analog-DigitalWandlers.
- Eine berührungslose Übertragung des Signals ist einfach und störungsarm möglich.
- Die Nullstellung der Messeinrichtung kann an einem externen Zähler vorgenommen werden; am eigentlichen Ladungsverstärker sind keinerlei Schaltungen vorzunehmen.
- Wird der Zähler gestoppt, bleibt das Messsignal beliebig lange erhalten.
- Dadurch, dass die Spannung am Verstärkerausgang und damit auch am Verstärkereingang meistens nur klein ist, wird der Einfluss des nur endlich grossen Isolationswiderstandes am Eingang verkleinert.

### Funktion der Bauteile und Dimensionierungshinweise (zu Fig. 3 und Fig.6)

Die Frequenz des Impulsgenerators G ist bei der Schaltung gemäss Fig. 3 so hoch zu wählen, dass der maximale zu erwartende Ladungssprung am Eingang innert jener Zeit kompensiert wird, die der noch zulässigen Verzögerung des Digitalsignals entspricht; die höchstmögliche Frequenz wird durch die gewählte Impulsbreite bestimmt. Bei der Schaltung gemäss Fig. 6 muss die Frequenz des Impulsgenerators G hoch genug sein, um sowohl eine genügende Auflösung des Messsignals zu erreichen, als auch die kurzen Kompensationsströme, welche durch Drifteffekte und weitere Störungen bedingt sind, genügend auflösen zu können, dass dadurch keine zusätzlichen Nullpunktabwanderungen des die P+- und P-- Impulse summierenden Zählers entstehen.

Die Referenzspannung Uref muss aus Stabilitätsgründen mindestens den Wert Qk/C1 aufweisen, wobei Qk die Kompensationsladungseinheit der Schaltung gemäss Fig. 3 bedeutet resp. bei der Schaltung gemäss Fig. 6 sinngemäss die kleinste bei einem Kompensationsvorgang an den Eingang gelieferte Ladung.

Von besonderem Interesse ist der Spezialfall, dass R2 niederohmig gewählt wird, im Extremfall sogar R2 = 0 Ohm. Dann gelangen die Kompensationsladungen Qk direkt an den Verstärkereingang. Die Kondensatoren C2 und C3 haben keine Wirkung mehr und können weggelassen werden. Die Spannung U3 nimmt ungefähr den Wert U1 an und ist somit vernachlässigbar klein.

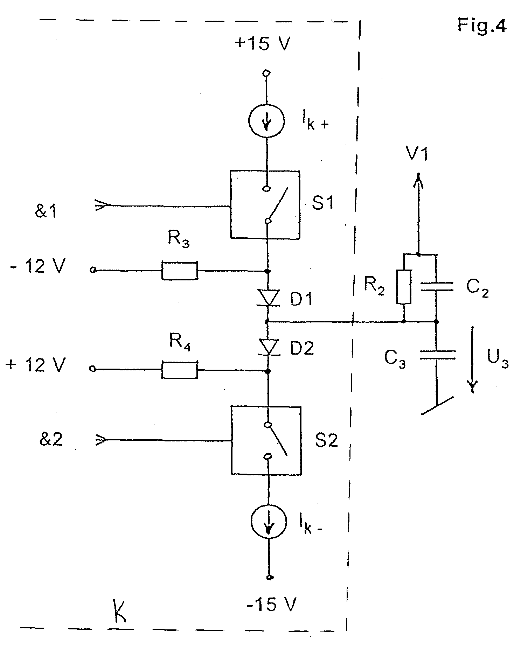

In Fig. 4 ist ein Teil des Schaltschemas von Fig. 3 mit 4 zusätzlichen Bauelementen gezeichnet. Die Schalter S1 und S2 werden vorzugsweise als Halbleiterschalter ausgeführt. Wenn die Leckströme dieser Schalter unzulässig gross sind, können sie durch in Serie mit den Schaltern eingefügte hochohmige Dioden D1 und D2 vermindert werden. Es kann vorteilhaft sein, die Dioden mittels der Widerstände R3 und R4 vorzuspannen, insbesondere, wenn R2 hochohmig ist und U3 dabei erheblich von 0V abweichende Werte erreichen kann. Diese Widerstände müssen dann etwas niederohmiger sein als die Dioden, aber doch so hochohmig, dass der durch sie fliessende Anteil von Ik vernachlässigbar klein ist. Im gezeigten Beispiel funktioniert diese Schaltung, solange U3 einen Wert von |11 V| nicht überschreitet.

### Ausführungsbeispiel

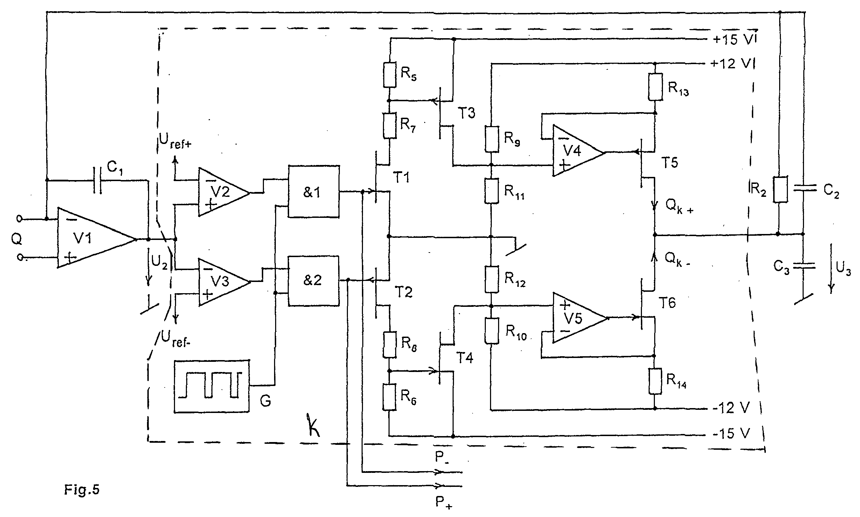

Fig. 5 zeigt eines der vielen möglichen Ausführungsbeispiele. In diesem Beispiel, welches eine Realisierung der Prinzipschaltung gemäss Fig. 3 darstellt, sind die Schalter S1 und S2 (von Fig. 3) in die Stromquellen integriert. Die beiden AND-Glieder &1 und &2 geben einerseits die Ausgangsimpulse P+ bzw. P- ab, andererseits steuern sie die Stromquellen über die Transistoren T1 bis T4. Die Stromquellen werden in bekannter Weise durch je einen Verstärker und einen Transistor gebildet.

Die sechs Transistoren sind hier ohne Differenzierung als FET-Transistoren dargestellt, ohne Rücksicht darauf, ob es Junction-FET oder MOS-FET sind.

Wenn die beiden AND-Glieder &1 und &2 Ausgangssignal 0 haben, sind die Transistoren T1 bis T4 leitend, T5 und T6 gesperrt; es werden keine Kompensationsladungen erzeugt.

Die Erzeugung einer Kompensationsladung Qk+ sei wie folgt beschrieben: Wenn an beiden Eingängen von &1 positives Signal anliegt, ist die Ausgangsspannung von &1 verschieden von 0. &1 sei so ausgeführt, dass dessen Ausgangsspannung dann negativ ist. Dadurch wird der selbstleitende Transistor T1 gesperrt und infolgedessen der selbstsperrende Transistor T3 ebenfalls. Nun liegt am +Eingang des Verstärkers V4 eine vom Spannungsteiler R9 und R11 gebildete Spannung an. Dadurch liegt am Widerstand R13 dieselbe Spannung wie am Widerstand R9, und der Strom durch diesen Widerstand ist damit der gewünschte Kompensationsstrom. Dieser fliesst durch den Transistor T5; nach Ablauf der Öffnungszeit von &1 ist somit die Kompensationsladung Qk+ in das Netzwerk R2, C2, C3 geflossen.

Wenn die beiden Eingangsspannungen an &2 positiv sind, ist die Ausgangsspannung von &2 von 0 verschieden. &2 sei so ausgeführt, dass dessen Ausgangsspannung dann positiv ist. An T2,T4, V5 und T6 geschieht dann auf gleiche Art, aber mit umgekehrten Vorzeichen, die Erzeugung der Kompensationsladung Qk-.

Der wandelbare Messbereich eines herkömmlichen Verstärkers ist umgekehrt proportional zur Kapazität des jeweils verwendeten Kondensators C1. Mit diesem erfindungsgemässen Ladungsverstärker ist nun aber die Wandlung eines grossen Messbereichs möglich, wobei dabei nur EIN Kondensator C1 notwendig ist. Das Umschalten zu verschiedenen Kondensatoren C1.1, C1.2, C1.3 ... verschiedener Kapazitäten, um verschiedene Messbereiche erfassen zu können, erübrigt sich hier, weil stets nur inkrementale Ladungen erfasst werden. Daher wird an diesen Kondensator C1 keine besonderen Ansprüche gestellt, insbesondere nicht an deren Isolation. Ein Ladungsverlust über C1 ist vernachlässigbar, weil die Spannung über C1 nur kurz anhält und keine Amplituden anstehen können. Daher kann ein Kondensator C1 mit einer niedrigen Kapazität gewählt werden. Da Kondensatoren mit grossen Kapazitäten sehr voluminös sind, wird zudem Platz gespart.

Zudem kann auf R1 gänzlich verzichtet werden.

Die Verwendung anderer als die hier in den Beispielen verwendeten Komponenten, welche zum selben Ziel führen, werden als Alternativlösungen im Sinne des Erfinders betrachtet.

### Bezugszeichenliste

- Q: Ladungsquelle (z.B. ein piezoelektrischer Messwertaufnehmer), bzw. die von ihm abgegebene Ladung Q.
- dQ/dt: der von der Ladungsquelle an den Verstärker V1 abgegebene Strom.
- Cq: Elektr. Kapazität von Ladungsquelle, Leitung und Verstärkereingang.
- Rq: Isolationswiderstand von Ladungsquelle, Leitung und Verstärkereingang,
- Rz: Zuleitungswiderstand, unter Umständen künstlich vergrössert durch Serieschaltung eines Festwiderstandes zur Vermeidung der Übersteuerung des Verstärkers V1 bei steilen Ladungsanstieg, wenn der vom Verstärkerausgang an C1 lieferbare Strom sonst nicht ausreichen würde, oder wenn man sonst C1 unerwünscht gross machen müsste.
- Iof: Offsetstrom des Verstärkers V1.
- Uoff: Offsetspannung des Verstärkers V1.
- L1: gesamter Eingangsstrom, dQ/dt + Iof + Iof /Rq.
- U1: Eingangsspannung am Verstärker V1.
- V1: hochohmiger Verstärker.
- C1: Gegenkopplungskondensator des Verstärkers V1. Dieser kann im allg. wesentlich kleiner als beim konventionellen Ladungsverstärker gewählt werden. Er muss lediglich so gross sein, dass er die noch nicht über die Kompensationsschaltung kompensierte Ladung am Eingang aufnehmen kann, ohne dass der Verstärker V1 übersteuert wird.
- U2: Spannung am Verstärkerausgang; diese wird infolge der Kompensationsschaltung immer wieder auf einen Wert < IUrefl gebracht.
- Uref+/Uref-: Referenzspannungen, ab welcher die Tätigkeit der Kompensationsschaltung einsetzt.
- V2, V3: Verstärker, welche als Komparatoren für den Vergleich zwischen U2 und den Referenzspannungen Uref wirken.
- G: Impulsgenerator, welcher Impulse definierter Breite und Frequenz liefert.
- &1, &2: AND-Glieder, welche ein positives Ausgangssignal abgeben, wenn die beiden Eingänge positives Signal aufweisen. Ihre Ausgänge betätigen die Schalter S1 und S2.
- &3, &4: AND-Glieder, welche bei positivem Ausgangssignal an V2 bzw. V3 die Impulse des Impulsgenerators G an die Ausgänge durchschalten.
- S1, S2: Schalter, welche die Kompensationsströme Ik+ bzw. Ik-schalten; im Fall von Fig. 3 schalten sie auch die Impulse des Impulsgenerators G an die Ausgänge durch.
- lk+, Ik-: wohldefinierte Stromquellen, welche während der Dauer eines Impulses des Impulsgenerators G jeweils eine exakte Ladung Qk+ bzw. Qk- an das Netzwerk R2, C2, C3 liefern.
- R2, C2: dienen der Übertragung der Kompensationsladungen an den Verstärkereingang, R2 muss so tief gewählt werden, dass der maximale Eingangsfehlerstrom (loff + Uof/Rq) kleiner als U3 max / R2 ist, denn der Fehlerstrom kann nur über R2 abfliessen.
- C3: dient dazu, die Kompensationsladungssprünge zu filtern und damit U3 zu stabilisieren. C3 wird vorteilhafterweise kleiner als C2 gewählt, um auf das Ausgangssignal keinen grossen Einfluss zu haben.
- U3: Spannung über C3; kann sich über den ganzen zulässigen Aussteuerbereich bewegen.
- Ü: 2-Kanal-Übertragungsweg für die Ausgangsimpulse P+ und P-, galvanisch, optisch, induktiv, kapazitiv oder hochfrequent über Sende- und Empfangsantenne.
- Z: Zähler für die Summierung der P+ und P- -Impulse. Der Zähler wird vorteilhafterweise für die Ausgabe positiver und negativer Werte ausgelegt.
- D: digitaler Zählerausgang, parallel oder seriell.
- R: Resetschalter zur Nullstellung des Zählers.
- S: Startschalter für den Start des Zählvorganges.
- Qk: bestimmt die Auflösung der Messvorrichtung. Wird eine Auflösung in z.B. 1000 Stufen (1%) gefordert, und wird der Messbereich voll ausgenützt, so darf Qk höchstens 1/1000 der maximalen Eingangsladung betragen. Entsprechend sind die Werte Ik und Impulsbreite des Impulsgenerators G zu wählen.

## Patentansprüche

1. Ladungsverstärkerschaltung zum Wandeln von positiven und negativen von einem piezoelektrischen Messelement abgegebenen Ladunqssignalen (Q) in ein digitales Signal (D), welches dem jeweils aktuell vorherrschenden Messwert am Messelement proportional ist, umfassend einen Ladungsverstärker (V1) mit einem Ladungseingang und einem Spannungsausgang zum Wandeln der erfassten Ladung (Q) in eine Spannung (U2), **dadurch gekennzeichnet, dass** dem Spannungsausgang des Ladungsverstärkers (V1) eine Kompensationsschaltung (K) umfassend zwei Ausgänge nachgeschaltet ist, wobei der erste Ausgang mit dem Ladungseingang des Ladungsverstärkers (V1) und der zweite Ausgang mit einem Zähler (Z) mit zwei Eingängen (Z+Z-) verbunden ist, und wobei die Kompensationsschaltung (K) einerseits eine der Spannung (U2) proportionale Kompensationsladung (Qk+, Qk-) erzeugen kann, welche zum Kompensieren des Eingangssignals (Q) über den ersten Ausgang zum Ladungseingang des Ladungsverstärkers (V1) sendbar ist, und wobei die Kompensationsschaltung (K) andererseits jeweils eine dem Betrag jeder erzeugten Kompensationsladung (Qk+, Qk-) proportionale Anzahl Impulse (P+, P-) erzeugen kann, welche über den zweiten Ausgang auf eine dem Vorzeichen der jeweiligen Kompensationsladung (Qk+, Qk-) entgegen gesetzten Eingang (Z-, Z+) des Zählers (Z) sendbar sind, wobei am Ausgang des Zählers (Z) das der Summe der vorgängig eingegangenen Ladungsquanten proportionale, gewünschte digitale Signal (D) zur Verfügung steht.

2. Schaltung nach Anspruch 1, **dadurch gekennzeichnet, dass** die Kompensationsschaltung (K) einen Impulsgenerator (G) umfasst zum Erzeugen von inkrementalen Impulsen (P), welche in ihrer Anzahl proportional zu den Ladungsänderungen am Verstärkereingang sind.

3. Schaltung nach 2, **dadurch gekennzeichnet, dass** dem Impulsgenerator (G) zwei AND-Glieder (&1, &2) parallel nachgeschaltet sind, welche eingangsseitig auch mit dem Ausgang des Ladungsverstärkers (V1) parallel verbunden sind und ausgangsseitig jeweils mit dem ersten Eingang (Z-) und dem zweiten Eingang (Z+) des Zählers verbunden sind, wobei die Impulse je nach Vorzeichen von U2 das Glied &1 oder &2 passieren und im Zähler (Z) bei dem ersten Eingang (Z-) oder dem zweiten Eingang (Z+) erfasst werden können.

4. Schaltung nach Anspruch 3, **gekennzeichnet durch** zwei Kompensationsverstärker (V2, V3), welche zwischen dem Ausgang des Ladungsverstärkers (V1) und den AND-Gliedern (&1, &2) parallel geschaltet sind.

5. Schaltung nach einem der vorhergehenden Ansprüche, **gekennzeichnet durch** zwei Stromquellen (Ik+, Ik-) zur Erzeugung der Kompensationsladungen (Qk+,Qk-).

6. Schaltung nach Anspruch 3 oder 4 und 5, **gekennzeichnet durch** zwei Schalter (S1,S2) nach je einem Ausgang der Stromquellen (Ik+, Ik-), welche eingangsseitig auch mit je einem der Ausgänge der AND-Glieder (&1, &2) verbunden sind, wobei die Schalter (S1, S2) während einer Impulsdauer Strom von den Stromquellen (Ik+, Ik-) zum Ladungseingang des Ladungsverstärkers (V1) senden können.

7. Schaltung nach Anspruch 6, **gekennzeichnet durch** Dioden (D1, D2), welche je einem der Schalter (S1, S2) in Serie nachgeschalten sind.

8. Schaltung nach Anspruch 4 und 5, **gekennzeichnet durch** zwei Schalter (S1, S2) nach je einem Ausgang der Stromquellen (Ik +,Ik-), welche eingangsseitig auch mit je einem der Ausgänge der Kompensationsverstärker (V2, V3) geschalten sind zum Durchlassen eines Stroms von der Stromquelle (Ik+) bei positiver Ausgangsspannung des ersten Kompensationsverstärkers (V2) oder von der Stromquelle (Ik-) bei negativer Ausgangsspannung des zweiten Kompensationsverstärkers (V3).

9. Schaltung nach einem der vorhergehenden Ansprüche, **dadurch gekennzeichnet, dass** als Schalter mindestens teilweise Transistoren oder mechanische Schalter verwendet werden.

10. Schaltung nach einem der vorhergehenden Ansprüche, **dadurch gekennzeichnet, dass** der Zähler einen Reset-Schalter (R) für die Zurückstellung des Zählers auf null und/oder einen Startschalter S für den Start des Zählvorgangs umfasst.

11. Schaltung nach einem der vorhergehenden Ansprüche, **gekennzeichnet durch** Mittel um die Zählimpulse unmoduliert oder einem Träger aufmoduliert galvanisch oder über induktive oder kapazitive oder optische Koppler oder Sende- und Empfangsantennen an den Zähler übermitteln zu können.

12. Schaltung nach einem der vorhergehenden Ansprüche, **dadurch gekennzeichnet, dass** das digitale Signal (D) ein Spannungssignal ist.

13. Verfahren zum Wandeln von positiven und negativen von einem piezoelektrischen Messelement abgegebenen Ladungssignalen (Q) in ein digitales Signal (D), welches dem jeweils aktuell vorherrschenden Messwert am Messelement proportional ist, **gekennzeichnet durch** die Schritte, dass ein Ladungsverstärker (V1) das eingehende Ladungssignal (Q) zu einem analogen Spannungssignal (U2) wandelt, das Spannungssignal (U2) in eine dem Ladungsverstärker (V1) nach geschalteten Kompensationsschaltung (K) geleitet wird, die Kompensationsschaltung (K) einerseits eine der Spannung (U2) proportionale Kompensationsladung (Qk+, Qk-) erzeugt und, zum Kompensieren des Eingangssignals (Q), über einen ersten Ausgang zum Ladungseingang des Ladungsverstärkers (V1) sendet, und dass die Kompensationsschaltung (K) andererseits jeweils eine dem Betrag jeder erzeugten Kompensationsladung (Qk+, Qk-) proportionale Anzahl Impulse (P+, P-) erzeuget und über einen zweiten Ausgang auf eine dem Vorzeichen der jeweiligen Kompensationsladung (Qk+, Qk-) entgegen gesetzten Eingang (Z-, Z+) eines Zählers (Z) sendet, welcher die Impulse aufsummiert und die jeweilige Summe als das gewünschte digitale Signal (D) liefert.

## Claims

1. Charge amplifier circuit for converting positive and negative charge signals (Q) that are output by a piezoelectric measuring element into a digital signal (D) that is proportional to the present measured value at the measuring element, comprising a charge amplifier (V1) having a charge input and a voltage output for converting the detected charge (Q) into a voltage (U2), **characterized in that** a compensation circuit (K) comprising two outputs is connected downstream of the voltage output of the charge amplifier (V1), wherein the first output is connected to the charge input of the charge amplifier (V1) and the second output to a counter (Z) having two inputs (Z+, Z-), and wherein on the one hand, the compensation circuit (K) can produce a compensation charge (Qk+, Qk-) respectively, that is proportional to the voltage (U2) and that can be sent to the charge input of the charge amplifier (V1) by means of the first output in order to compensate the input signal (Q), and wherein on the other hand the compensation circuit (K) can produce a number of pulses (P+, P-) that is proportional to the magnitude of each compensation charge (Qk+, Qk-) produced, and said pulses can to be sent to an input (Z-, Z+) of the counter (Z) opposite the sign of the particular compensation charge (Qk+, Qk-) by means of the second output, wherein the desired digital signal (D), which is proportional to the sum of the charge quanta input beforehand, is available at the output of the counter (Z).

2. The circuit according to Claim 1, **characterized in that** the compensation circuit (K) comprises a pulse generator (G) for generating incremental pulses (P), the number of which is proportional to the changes in charge at the amplifier input.

3. The circuit according to Claim 2, **characterized in that** two AND gates (&1, &2) are connected in parallel downstream of the pulse generator (G), said gates also being connected at the input side in parallel with the output of the charge amplifier (V1) and each being connected at the output side to the first input (Z-) and to the second input (Z+) of the counter respectively, wherein depending on the sign of (U2), the pulses pass through the gate &1 or &2 and can be detected in the counter (Z) at the first input (Z-) or the second input (2+).

4. The circuit according to Claim 3, **characterized by** two compensation amplifiers (V2, V3), which are connected in parallel between the output of the charge amplifier (V1) and the AND gates (&1, &2) respectively.

5. The circuit according to any one of the preceding claims, **characterized by** two current sources (Ik+, Ik-) for generating the compensation charges (Qk+, Qk-).

6. The circuit according to Claim 3 or 4 and 5, **characterized by** two switches (S1, S2) each downstream of one output of the current sources (Ik+, Ik-), which are also each connected at the input side to one of the outputs of the AND gates (&1, &2), wherein the switches (S1, S2) can send current from the current sources (Ik+, Ik-) to the charge input of the charge amplifier (V1) during a pulse duration.

7. The circuit according to Claim 6, **characterized by** diodes (Dl, D2), which are connected downstream to one each of the switches (S1, S2) in series.

8. The circuit according to Claim 4 and 5, **characterized by** two switches (S1, S2) downstream of one output each of the current sources (Ik+, Ik-), which at the input side are also each connected to one of the outputs of the compensation amplifier (V2, V3), to allow a current to pass from the current source (Ik+) in the case of a positive output voltage of the compensation amplifier (V2), or from the current source (Ik-) in the case of a negative output voltage of the compensation amplifier (V3).

9. The circuit according to any one of the preceding claims, **characterized in that** transistors or mechanical switches are used as switches, at least in part.

10. The circuit according to any one of the preceding claims, **characterized in that** the counter comprises a reset switch (R) for resetting the counter to zero and/or a start switch (S) for starting the counting process.

11. The circuit according to any one of the preceding claims, **characterized by** means to enable the counter pulses to be transmitted unmodulated or modulated onto a carrier, galvanically or by inductive or capacitive or optical couplers or transmitter and receiver antennas, to the counter.

12. The circuit according to any one of the preceding claims, **characterized in that** the digital signal (D) is a voltage signal.

13. Method for converting positive and negative charge signals (Q) that are output by a piezoelectric measuring element into a digital signal (D) that is proportional to the present measured value at the measuring element, **characterized by** the steps that: a charge amplifier (V1) converts the input charge signal (Q) into an analogue voltage signal (U2), the voltage signal (U2) is passed into a compensation circuit (K) downstream of the charge amplifier (V1), on the one hand the compensation circuit (K) produces a compensation charge (Qk+, Qk-) that is proportional to the voltage (U2) and, to compensate the input signal (Q), sends it to the charge input of the charge amplifier (V1) by means of a first output, and that on the other hand the compensation circuit (K) produces a number of pulses (P+, P-) that is proportional to the magnitude of each compensation charge (Qk+, Qk-) produced and sends them to an input (Z-, Z+) of the counter (Z) opposite the sign of the particular compensation charge (Qk+, Qk-) by means of the second output, and said counter sums the pulses and delivers the respective sum as the desired digital signal (D).

## Revendications

1. Un circuit d'amplificateur de charge pour transformer des signaux de charge (Q) positifs et négatifs générés en sortie d'un élément de mesure piézoélectrique en signal numérique (D) proportionnel à la valeur mesurée actuelle dans l'élément de mesure, comprenant un amplificateur de charge (V1) ayant une entrée de charge et une sortie de tension pour convertir la charge détectée (Q) en une tension (U2), **caractérisé en ce qu'**un circuit de compensation (K) comprenant deux sorties est raccordé en aval de la sortie de tension dudit amplificateur de charge (V1), dans lequel la première sortie est raccordée à l'entrée de charge de l'amplificateur de charge (V1) et la deuxième sortie est raccordée à un compteur (Z) ayant deux entrées (Z+, Z-), et dans lequel, d'une part, le circuit de compensation (K) peut produire une charge de compensation (Qk+, Qk-) proportionnelle à la tension (U2) et apte à être transmise à l'entrée de charge de l'amplificateur de charge (V1) par l'intermédiaire de la première sortie afin de compenser le signal d'entrée (Q), et dans lequel, d'autre part, le circuit de compensation (K) peut produire un nombre d'impulsions (P+, P-) proportionnel à la grandeur de chaque charge de compensation (Qk+, Qk-) produite, lesdites impulsions étant aptes à être transmises par l'intermédiaire de la deuxième sortie à une entrée (Z-, Z+) du compteur (Z) ayant une polarité opposée à celle de la charge de compensation (Qk+, Qk-), dans lequel ledit signal numérique (D) souhaité qui est proportionnel à la somme des quanta de charge entrés au préalable, est disponible à la sortie du compteur (Z).

2. Le circuit selon la revendication 1, **caractérisé en ce que** ledit circuit de compensation (K) comprend un générateur d'impulsions (G) pour générer des impulsions incrémentales (P) dont le nombre est proportionnel aux changements de charge au niveau de l'entrée de l'amplificateur.

3. Le circuit selon 2, **caractérisé en ce que** deux portes ET (&1, &2) sont raccordées en parallèle en aval du générateur d'impulsions (G), lesdites portes étant aussi branchées sur le côté d'entrée en parallèle à la sortie de l'amplificateur de charge (V1) et chacune étant connectée sur le côté de la sortie respectivement à la première entrée (Z-) et à la deuxième entrée (Z+) du compteur, dans lequel les impulsions traversent la porte &1 ou &2 selon la polarité de U2 et peuvent être détectées dans le compteur (Z) à la première entrée (Z-) ou à la deuxième entrée (Z+).

4. Le circuit selon la revendication 3, **caractérisé par** deux amplificateurs de compensation (V2, V3) branchés en parallèle entre la sortie de l'amplificateur de charge (V1) et les portes ET (&1, &2).

5. Le circuit selon l'une des revendications précédentes, **caractérisé par** deux sources de courant (Ik+, Ik-) pour produire les charges de compensation (Qk+, Qk-).

6. Le circuit selon la revendication 3 ou 4 et 5, **caractérisé par** deux commutateurs (S1, S2) chacun situé en aval d'une sortie des sources de courant (Ik+, Ik-) qui sont aussi connectés sur le côté d'entrée chacun à l'une des sorties des portes ET (&1, &2), lesdits commutateurs (S1, S2) étant aptes à transmettre un courant desdites sources de courant (Ik+, Ik-) à l'entrée de charge de l'amplificateur de charge (V1) pendant une durée d'impulsion.

7. Le circuit selon la revendication 6, **caractérisé par** des diodes (D1, D2) chacune reliée en série en aval à l'un des commutateurs (S1, S2).

8. Le circuit selon la revendication 4 et 5, **caractérisé par** deux commutateurs (S1, S2) chacun situé en aval d'une des sorties des sources de courant (Ik+, Ik-), dans lequel chacun étant aussi connecté sur le côté d'entrée à l'une des sorties de l'amplificateur de compensation (V2, V3) afin de faire passer un courant de la source de courant (Ik+) en cas d'une tension de sortie positive du premier amplificateur de compensation (V2), ou de la source de courant (Ik-) en cas d'une tension de sortie négative du deuxième amplificateur de compensation (V3).

9. Le circuit selon l'une des revendications précédentes, **caractérisé en ce que** des transistors ou des commutateurs mécaniques sont utilisés comme commutateurs, au moins en partie.

10. Le circuit selon l'une des revendications précédentes, **caractérisé en ce que** le compteur comprend un commutateur de remise a zéro (R) pour remettre le compteur à zéro, et/ou un commutateur de démarrage (S) pour démarrer le processus de comptage.

11. Le circuit selon l'une des revendications précédentes, **caractérisé par** des moyens afin de pouvoir transmettre au compteur les impulsions de comptage non modulées ou modulées sur une porteuse, de façon galvanique ou par des coupleurs inductifs ou capacitifs ou optiques ou des antennes d'émission et de réception.

12. Le circuit selon l'une des revendications précédentes, **caractérisé en ce que** le signal numérique (D) est un signal de tension.

13. Un procédé pour transformer des signaux de charge (Q) positifs et négatifs générés en sortie d'un élément de mesure piézoélectrique en signal numérique (D) proportionnel à la valeur mesurée actuelle dans l'élément de mesure, procédé **caractérisé par** les étapes dans lesquelles un amplificateur de charge (V1) transforme le signal de charge (Q) entrant en un signal de tension analogique (U2), ledit signal de tension (U2) est introduit dans un circuit de compensation (K) raccordé en aval dudit amplificateur de charge (V1), ledit circuit de compensation (K), d'une part, produit une charge de compensation (Qk+, Qk- ) proportionnelle à la tension (U2), et, afin de compenser le signal d'entrée (Q), la transmet par l'intermédiaire d'une première sortie à l'entrée de charge de l'amplificateur de charge (V1), et en ce que le circuit de compensation (K), d'autre partie, produit un nombre d'impulsions (P+, P-) proportionnel à la grandeur de chaque charge de compensation (Qk+, Qk-) produite et les transmet par l'intermédiaire d'une deuxième sortie à une entrée (Z-, Z+) du compteur (Z) ayant une polarité opposée à celle de la charge de compensation (Qk+, Qk-), compteur qui additionne les impulsions et fournit la somme respective en tant que ledit signal numérique (D) souhaité.
